# EUROPEAN PATENT APPLICATION

(11) **EP 1 003 209 A1**
(43) Date of publication of application: **24.05.2000**
(21) Application number: 99308974.7
(22) Date of filing: 11.11.1999
(51) Int. Cl.: H01L 21/288, H01L 21/60, H01L 23/532

(54) **Process for manufacturing semiconductor device**

(30) Priority: 17.11.1998 JP 32639698
(71) Applicant: SHINKO ELECTRIC INDUSTRIES CO. LTD., Nagano-shi, Nagano 380-0921 (JP)
(72) Inventor: Ihara, Yoshihiro, Nagano-shi, Nagano 380-0921 (JP); Kobayashi, Tsuyoshi, Nagano-shi, Nagano 380-0921 (JP)
(74) Representative: Rackham, Stephen Neil

(57) **Abstract**

A semiconductor device (1) is provided with patterned wirings (12) connecting electrode terminals (2) of a semiconductor element to external connection terminals (18) for electrical connection of the semiconductor device to external circuits. The patterned wirings (12) are formed by forming a film of a first metal (6) on which it is difficult to deposit an electrolytic plating film. Forming a film of a second metal (7) on the film of the first metal, and a resist pattern (8) on the film of the second metal (7). Forming a patterned first plating film (9) using the resist pattern (8) as a mask, removing the resist pattern (8) and the film of the second metal (7) to expose the film of the first metal (6) and the sides of the second metal (7) left under the first plating film (9). Electrolytically plating the first plating film (9) and the exposed sides of the film of the second metal (7) thereunder with a metal to form a second plating film, (10,11) and removing the exposed film of the first metal (6) using the second plating film (10,11) as a mask. Preferably, the first metal (6) is titanium, chromium, tungsten or an alloy of titanium and tungsten.

## Description

The invention relates to a process for manufacturing a semiconductor device.

A semiconductor device is made up mainly of a semiconductor element individually separated from a wafer which comprises a large number of semiconductor elements manufactured in one lot. The separated semiconductor element, also called a bare chip, may or may not be encapsulated by a package formed of a molding material, such as a resin material, and is mounted on a substrate, such as a printed circuit board. Recently, mounting a bare chip semiconductor device on a substrate has become common.

In the case where a bare chip is used as a semiconductor device to be mounted on a substrate, metal bumps are formed on the bare chip to allow the chip to be electrically connected to the substrate through the bumps. Thus, the bumps are formed at the locations corresponding to the locations of pads provided on the substrate for the mounting and, in general, each bump is provided at an appropriate point, mostly an end, of a patterned wiring connected to a pad (or an electrode terminal) of the bare chip.

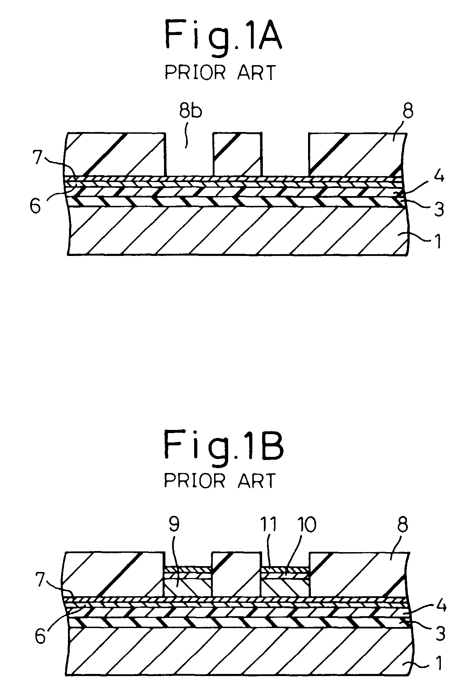

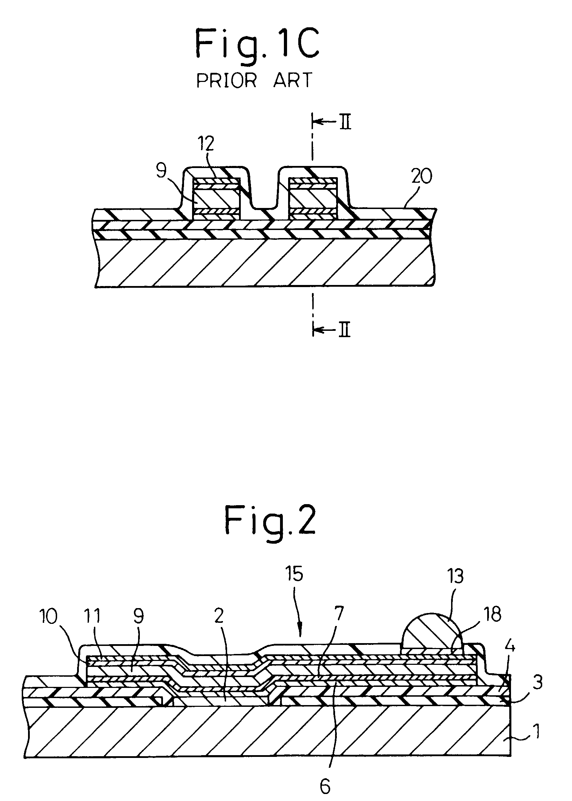

Figs. 1A to 1C illustrate a prior process for forming such patterned wirings on a semiconductor element, and Fig. 2 illustrates a semiconductor device having patterned wirings and accompanying bumps, and represents a cross section taken along the line II - II of Fig. 1C. As shown in these drawings, a semiconductor element 1 comprises pads or electrodes 2 made of, for example, aluminum, a passivation film 3, and a protective film 4. The pads 2 are formed at the openings of the passivation film 3. The protective film 4 fully covers the passivation film 3, and exposes the top face of the pads 2.

Referring to Fig. 1A, a film 6 of a first metal, such as titanium, is formed to cover the pads 2 (Fig. 2) and the protective film 4, and on the formed film 6, a film 7 of a second metal, such as copper, is then formed. Subsequently, a resist layer is formed on the film 7 of the second metal, and is then patterned by a photolithography technique to provide a resist pattern 8 having trenches 8b for the formation of a wiring pattern.

Using the resist pattern 8 as a mask, a copper film 9 is formed by electrolytic plating on the film 7 of the second metal at the bottom of the trench 8b, as shown in Fig. 1B. Subsequently, an electrolytic plating film of nickel 10 is formed on the copper film 9, and an electrolytic plating film of gold 11 is then formed on the nickel film 10.

Next, the resist pattern 8 is removed, and the film 7 of the second metal and the film 6 of the first metal are then selectively removed by etching, to thereby form patterned wirings 12, as shown in Fig. 1C. Using solder balls, bumps 13 are then formed on a land 18 provided at an appropriate point of the patterned wirings 12, as shown in Fig. 2, to provide a semiconductor device 15. In most cases, a protective film 20 having openings for the bumps 13 is formed to protect the patterned wirings 12 before or after the formation of the bumps 13.

The film 6 of the first metal serves as a barrier layer preventing diffusion between the copper of the overlying films 7 and 9 and the aluminum of the underlying pads 2 to improve adhesion to the pads 2, and also functions to improve adhesion to the protective film 4. The film 7 of the second film serves as an underlayer for the formation of the electrolytic plating film of copper 9 which will provide the wiring pattern. The films 6 and 7 also function as electrically conductive layers during the electrolytic plating.

In practice, a large number of bare chips are produced together on a wafer and are finally separated from the wafer.

The prior process described above is preferred because patterned wirings 12 having a desired thickness are formed by electrolytic copper plating. Nevertheless, there is a problem of that the sides of the patterned wiring 12 are exposed by the removal of the resist pattern 8, and the exposed side of the patterned wiring 12 includes the side of the copper film 9 (see Fig. 1C), so that troubles, such as migration of copper into the protective film 20 resulting in reduced insulating characteristics of the protective film between adjacent wirings, can arise.

An object of the invention is to provide a process for manufacturing a semiconductor device in which a patterned wiring connecting an electrode terminal of an semiconductor element (chip) to a bump for external connection has sides covered by a film, to thereby solve the problem.

The invention provides a process for manufacturing a semiconductor device comprising a semiconductor element provided with electrode terminals of the semiconductor element, external connection terminals for electrical connection of the semiconductor device to external circuits, and patterned wirings for electrical connection between the respective electrode terminals and the respective external connection terminals, wherein the patterned wirings are formed by the following steps of:
forming a film of a first metal to cover the electrode terminals and the protective film of the semiconductor element, it being difficult to deposit an electrolytic plating film on its surface,
forming a film of a second metal on the film of the first metal,
forming a resist pattern on the film of the second metal, the resist pattern having openings partially exposing the underlying film of the second metal,
electrolytically plating the exposed film of the second metal at the bottoms of the openings with a metal using the resist pattern as a mask, to thereby form a patterned first plating film,
removing the resist pattern to expose the film of the second metal,
removing the exposed film of the second metal using the patterned first plating films as a mask, to thereby expose the film of the first metal and the sides of the film of the second metal left under the first plating film,
electrolytically plating the first plating film and the exposed sides of the film of the second metal thereunder with a metal, to thereby form a second plating film, and
removing the exposed film of the first metal using the second plating film as a mask, to thereby expose the protective film.

Preferably, the first metal is selected from the group consisting of titanium, chromium, tungsten, and an alloy of titanium and tungsten.

Preferably, the second metal is selected from the group consisting of copper and nickel.

Preferably, the first plating film is formed of copper.

Preferably, the second plating film includes layers of nickel and gold.

Preferably, the films of the first and second metals are formed by sputtering.

Preferably, a protective film is formed after the formation of the patterned wirings.

Preferably, the protective film formed after the formation of the patterned wirings is made of a polyimide resin.

According to the invention, since the resist pattern is removed and the exposed film of the second metal is also removed before the second plating film is formed, the second plating film can be formed on the sides of both first plating film and film of the second metal left thereunder as well as on the top of the first plating film. A metal for the first film, such as titanium, chromium, tungsten, and an alloy of titanium and tungsten, has a high electric resistance, and an oxidized surface which does not allow electric current to pass easily. Accordingly, the second plating film is not formed on the exposed film of the first metal during the formation of the second plating film by electrolytic plating, which means that the second plating film can be selectively and easily formed on the sides of the patterned wiring without a particular mask means.

Particular embodiments in accordance with this invention will now be described with reference to the accompanying drawings; in which:-
Figs. 1A to 1C illustrate a prior process for the formation of patterned wirings;
Fig. 2 shows a cross section of the semiconductor device taken along the line II - II of Fig. 1, the device provided with a patterned wiring connecting an electrode of a semiconductor element to a bump for external connection;
Figs. 3A to 3G illustrate an embodiment of the process of the invention;
Fig. 4 illustrates patterned wirings formed by the process of the invention; and
Figs. 5A to 5E illustrate another embodiment of the process of the invention.

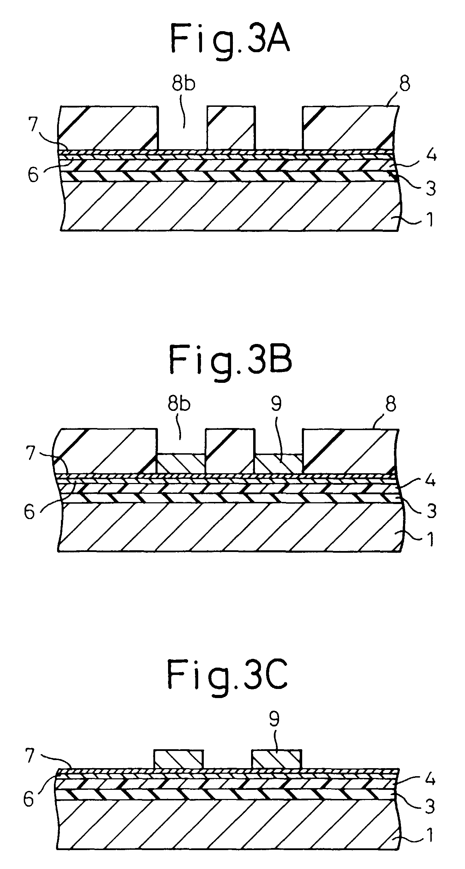

An embodiment of the invention is illustrated in Figs. 3A to 3G. A resultant semiconductor device will have a structure of stacked layers which is the same as that shown in Fig. 2, and therefore, members in Figs. 3A to 3G which are the same as those in Fig. 2 are identified by the reference numerals used in Fig. 2.

In Fig. 3A, an semiconductor element (bare chip) 1, in which certain active devices (not shown) such as transistors and wiring (not shown) are formed, is shown, the semiconductor element being provided with a passivation film 3 (several hundreds angstroms thick) made of an insulation material such as SiO₂, and a protective film 4 (5 to 20 micrometers thick) of an insulation material, such as a polyimide resin, formed over the passivation film 3. Additionally, as shown in Fig. 2, the semiconductor element 1 is also provided with pads or electrode terminals 2 formed of, for example, aluminum, to be left uncovered by the passivation film 3 and the protective film 4.

A film 6 (0.1 to 0.5 micrometers thick) of a first metal, such as titanium, chromium, tungsten, or an alloy of titanium and tungsten, is formed by sputtering to cover the pads (Fig. 2) and the protective film 4, and subsequently, a film 7 (0.2 to 1.0 micrometers thick) of a second metal, such as copper or nickel, is formed on the film 6 also by sputtering. A photo-sensitive resist layer is then formed on the film 7 of the second metal, and is patterned by a known photolithography technique to thereby provide a resist pattern 8 having trenches 8b for the formation of a wiring pattern.

By electrolytical plating using the resist pattern 8 as a mask, a metal such as copper is then deposited on the film 7 exposed at the bottom of the trenches 8b, to form a first plating film 9 having a required thickness, for example, 1 to 50 micrometers, as shown in Fig. 3B.

Subsequently, the resist pattern 8 is removed, to thereby expose the film 7, as shown in Fig. 3C.

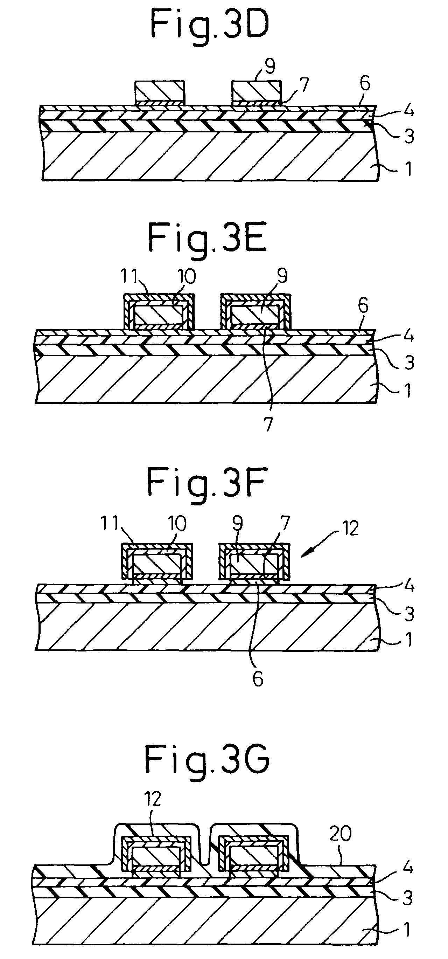

The exposed film 7 is then removed by etching, to thereby expose the film 6, as shown in Fig. 3D. Although the first plating film 9 of copper is more or less etched by an etchant used during the etching, the film 9 has a relatively larger thickness than that of the film 7, and is, in practice, little affected by the etchant.

By subsequent electrolytic plating, the first plating film 9 and the exposed sides of the underlying film 7 are plated with nickel, and then with gold to thereby form a second plating film consisting of a nickel layer 10 (1 to 5 micrometers thick) and a gold layer 11 (0.1 to 3 micrometers thick), as shown in Fig. 3E.

During the electrolytic plating, no plating films are formed on the exposed film 6 of the first metal. This may be explained as follows. The first metal for the film 6, such as titanium, chromium, tungsten, and an alloy of titanium and tungsten, has a high electric resistance, and is very easily oxidized. The oxidized film is not easily removed even by a pretreatment for the formation of plating film 10 of nickel. In addition, the oxidized film does not allow electric current to pass easily. Consequently, the film 6 of the first metal is not plated during the formation of the second plating film, and the second plating film can be exclusively and easily formed on the stack of the first plating film 9 and the underlying film 7 which subsequently forms into a patterned wiring.

After the formation of the second plating film comprising the layers 10 and 11, the exposed and unplated film 6 of the first metal is selectively removed by etching using the plated stack of the films 7 and 9 as a mask, to provide a patterned wiring 12 having both top and sides covered by the plating film, as shown in Fig. 3F. In this case, although the sides of the film 6 left under the stack are exposed, the film 6 has a relatively smaller thickness of several hundreds angstroms, and migration of the metal of the film 6 is negligible.

Subsequently, lands 18 (Fig. 2) are provided on an appropriate point of the patterned wirings 12, and, using solder balls or bonding wires, bumps 13 are formed on the lands 18, as illustrated in Fig. 2, to provide a semiconductor device 15.

Before or after the formation of the bumps 13 (Fig. 2), a protective film 20 having openings for the bumps 13 may be formed of, for example, a polyimide resin, to protect the patterned wirings 12, as shown in Figs. 2 and 3G.

A semiconductor wafer (not shown) on which a number of semiconductor devices are formed is then diced to be divided into individual semiconductor devices.

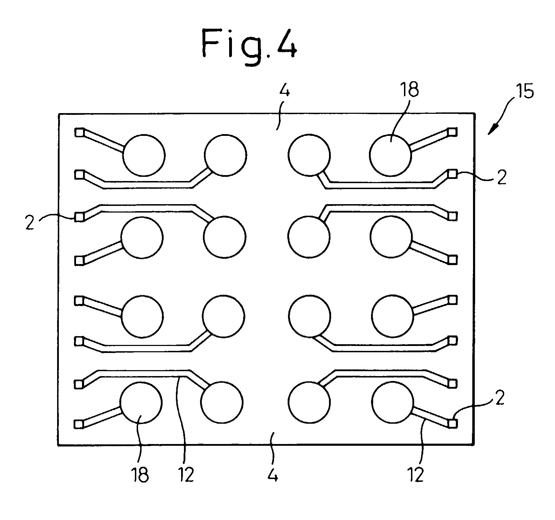

The semiconductor device 15 produced by the process of the invention comprises a plurality of patterned wirings 12 on the protective film 4, which connect a pad or electrode terminal 2 of an semiconductor element and a land 18 on which a bump (not shown) is to be formed for external connection, as shown in Fig. 4, and which have the sides provided with the plating film as seen in Fig. 3F. The wirings 12 may be covered by a protective film (not shown), as earlier described.

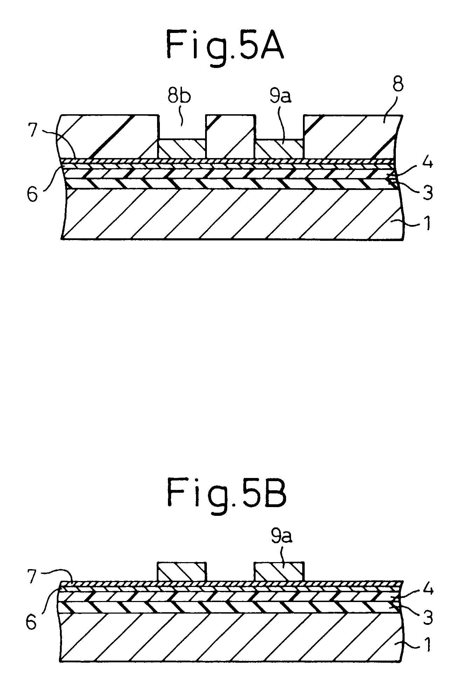

Another embodiment of the invention is illustrated in Figs. 5A to 5E. In this embodiment, subsequent to the formation of a resist pattern 8 having trenches 8b as earlier illustrated in Fig. 3A, a film of nickel rather than copper is deposited on the film 7 exposed at the bottom of the trenches 8b by electrolytic plating, to provide a first plating film 9a, as shown in Fig. 5A.

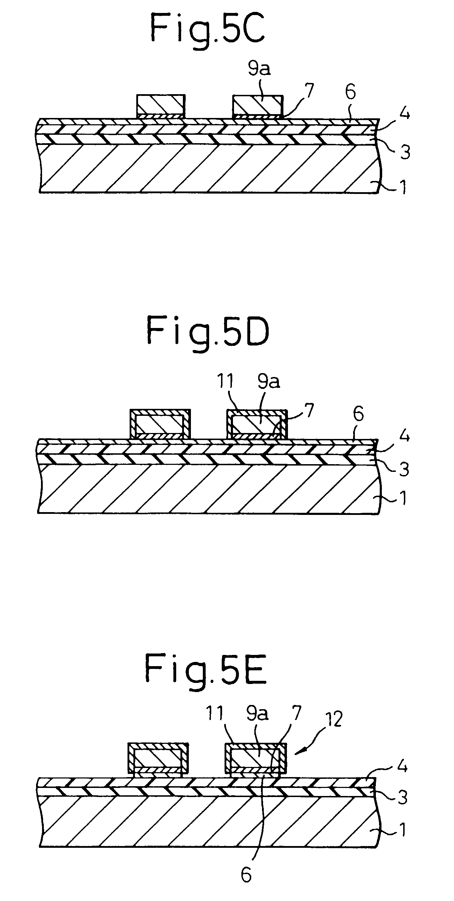

The resist pattern 8 is then removed, to thereby expose the film 7, as shown in Fig. 5B. Subsequently, the exposed film 7 is removed by etching, to expose the film 6, as shown in Fig. 5C.

The top and sides of the nickel film 9a and the exposed sides of the film 7 left thereunder are then electrolytically plated with gold to form a gold plating film (a second plating film) 11, as shown in Fig. 5D. Thus, in this embodiment, the first plating film 9a of nickel is not required to be plated with further nickel, and can be plated directly with gold to form the second plating film 11.

The exposed and unplated film 6 is then selectively removed by etching using the plated stack of the films 7 and 9a as a mask, to provide a patterned wiring 12 having both top and sides covered by the plating film 11, as shown in Fig. 5E.

Subsequently, lands 18 and bumps 13 (Fig. 2) are formed at an appropriate point of the patterned wirings 12 to provide a semiconductor device 15, as earlier described. Also, before or after the formation of the bumps 13, a protective film 20 having openings for the bumps 13 may be formed, as shown in Fig. 2.

The semiconductor device obtained according to the process of the invention has a structure of stacked layers which is illustrated in Fig. 2, and can be characterized by the patterned wiring 12 having the sides provided with the plating film, wherein the plating film may comprise one or more layers 10 and 11 as shown in Figs. 3F and 5E.

In the invention, the first metal material for the film 6 located on the protective film 4 may be any metal material, or alternatively any alloy of two or more metals, on which an electrolytic plating film, particularly a second plating film 9 or 9a, cannot be deposited, and is not limited to those referred to above. The second metal material for the film 7 provided on the film 6 of the first metal is also not limited to those referred to above. Similarly, the material for the first plating film 9 or 9a forming a body of a patterned wiring 12 as well as the material for the second plating film 10, 11 are not always limited to those referred to above.

Although the invention has been described for a single semiconductor device, a person with ordinary skill in the art would well understand that such a semiconductor device is manufactured together with others on a wafer, and is then separated from the wafer into a product semiconductor device, which is also called a semiconductor chip.

## Claims

1. A process for manufacturing a semiconductor device comprising a semiconductor element provided with electrode terminals of the semiconductor element, external connection terminals for electrical connection of the semiconductor device to external circuits, and patterned wirings for electrical connection between the respective electrode terminals and the respective external connection terminals, wherein the patterned wirings are formed by the following steps of:
forming a film of a first metal to cover the electrode terminals and the protective film of the semiconductor element, it being difficult to deposit an electrolytic plating film on-its surface,
forming a film of a second metal on the film of the first metal,
forming a resist pattern on the film of the second metal, the resist pattern having openings partially exposing the underlying film of the second metal,
electrolytically plating the exposed film of the second metal at the bottoms of the openings with a metal using the resist pattern as a mask, to thereby form a patterned first plating film,
removing the resist pattern to expose the film of the second metal,
removing the exposed film of the second metal using the patterned first plating films as a mask, to thereby expose the film of the first metal and the sides of the film of the second metal left under the first plating film,
electrolytically plating the first plating film and the exposed sides of the film of the second metal thereunder with a metal, to thereby form a second plating film, and
removing the exposed film of the first metal using the second plating film as a mask, to thereby expose the protective film.

2. A process according to claim 1, wherein the first metal is selected from the group consisting of titanium, chromium, tungsten, and an alloy of titanium and tungsten.

3. A process according to claim 1 or 2, wherein the second metal is copper or nickel.

4. A process according to any one of the preceding claims, wherein the first plating film is formed of copper.

5. A process according to any one of the preceding claims, wherein the second plating film includes layers of nickel and gold, or is formed of gold.

6. A process according to any one of the preceding claims, wherein the films of the first and second metals are formed by sputtering.

7. A process according to any one of the preceding claims, wherein a protective film is formed after formation of the patterned wirings.

8. A process of claim 7, wherein the protective film is formed of a polyimide resin.
